# EUROPEAN PATENT APPLICATION

(11) **EP 3 654 510 A1**
(43) Date of publication of application: **20.05.2020**
(21) Application number: 18207070.6
(22) Date of filing: 19.11.2018
(51) Int. Cl.: H02M 1/36, H02M 7/483, G01R 31/40

(54) **PRE-CHARGING A MODULAR MULTILEVEL CONVERTER**

(71) Applicant: Maschinenfabrik Reinhausen GmbH, 93059 Regensburg (DE)
(72) Inventor: Ali, Waqas, 93053 Regensburg (DE); Bissal, Ara, 93055 Regensburg (DE)

(57) **Abstract**

An MMC comprises an arm (A) with a plurality of submodules (SM1, ..., SMN) coupled in series. Each of the submodules comprises a capacitor (C). The MMC further comprises a control unit (CU) configured to control a pre-charging process of the capacitors (C) prior to a start of operation of the MMC. The control unit (CU) is configured to connect the arm (A) to a constant voltage source for a first period of time. The control unit (CU) is configured to feed a charging current to the arm (A) and control the charging current at a predetermined constant reference current for a second period of time.

## Description

The invention relates to a modular multilevel converter, MMC, a high voltage testing source comprising an MMC, a method for controlling a pre-charging process for an MMC and a method for high voltage testing of an electrical device.

Prior to nominal operation of an MMC, the capacitors of the MMC may be pre-charged for example to reduce a start-up time of the MMC or to avoid damage of MMC components due to large inrush currents. Known approaches may rely on circuit details and thus may be prone to variations and disturbances. Furthermore, the capacitors may be charged to voltages beyond their rating due to overshoots, which may lead to increased degeneration of the capacitors and as a consequence to a reduced lifetime of the MMC. The impact of this effect is more important the higher a turn-on rate or a restart rate of the MMC is, in other words the more often the MMC is brought from black start back to live operation. In particular, high voltage testing sources may be used for numerous tests within one or several days and have to be shut down and restarted for each test. Thus, the reduced lifetime of the MMC is of particular relevance if the MMC is designed or intended for high voltage testing.

Therefore, it is an objective to provide an improved concept for pre-charging a modular multilevel converter that avoids a reduced lifetime of the modular multilevel converter.

This objective is achieved by the subject matter of the independent claims. Further implementations and embodiments are subject matter of the dependent claims.

The improved concept is based on the idea to split the pre-charging process into two stages. In a first stage, capacitors of a converter arm are pre-charged to reach an intermediate pre-charging voltage across the arm in an uncontrolled manner. In the second stage, a controlled constant charging current is used to reach a target pre-charging voltage across the arm.

According to the improved concept, an MMC for a high voltage testing source is provided. The MMC comprises an arm with a plurality of submodules coupled in series to each other. Each of the submodules comprises a capacitor. The MMC further comprises a control unit configured to control a pre-charging process of the capacitors prior to a start of operation, in particular nominal operation, of the MMC. For controlling the pre-charging process, the control unit is configured to connect the arm to a constant voltage source, in particular DC voltage source, for a first period of time. The control unit is configured to feed a charging current to the arm and control the charging current at a predetermined constant reference current for a second period of time after the first period of time.

During the first period, the pre-charging process is uncontrolled and a voltage across the arm increases from a start voltage, which is for example zero or close to zero, to an intermediate pre-charging voltage. Due to the lack of control, the intermediate pre-charging voltage is completely defined by the capacitances of the capacitors, an output voltage of the voltage source, a duration of the first period and, if applicable, a resistance of a charging resistor. If the duration of the first period is sufficiently long, the intermediate pre-charging voltage is equal or approximately equal to the output voltage of the voltage source. During the first period, a charging current flowing in the arm is time dependent and goes to zero for a sufficiently long duration of the first period.

During the second period, the charging current is controlled to stay constant at the reference current or within a predefined tolerance range around the reference current. Therefore, the voltage across the arm increases during the second period from the intermediate pre-charging voltage to a target pre-charging voltage, determined essentially by the reference current and the duration of the second period.

By combining the uncontrolled and controlled pre-charging stage, a fast pre-charging of the capacitors may be achieved without significant overshoots that would increase the degeneration of the capacitors. This is particularly advantageous for applications, where the MMC has to be restarted relatively often, for example for use of the MMC in a high voltage testing source. The first stage makes sure that the control unit is supplied with a sufficiently high voltage to perform the control during the second stage.

According to several embodiments of the MMC, the control unit is configured to control the charging current based on a closed loop control.

According to several embodiments, the MMC or the high volt testing source comprises a charging resistor that is coupled or connectable between the arm and the constant voltage source. By means of the charging resistor, the charging current may be limited, in particular during the first period of time.

According to several embodiments, the control unit is configured to bypass the charging resistor during the second period of time.

According to several embodiments, each of the submodules comprises a switching arrangement for inserting, bypassing and/or blocking the respective submodule.

According to several embodiments, the switching arrangement and the capacitor of a respective submodule are arranged according to a full-bridge or a half-bridge topology. According to several embodiments, each switching arrangement comprises a first and a second switching element. The switching elements and the respective capacitor of one of the submodules are arranged according to a half-bridge topology.

According to several embodiments, the control unit is configured to, for inserting one of the plurality of submodules, close the first switching element and open the second switching element of the respective submodule such that the capacitor of the respective submodule may be charged or discharged depending on the direction of the current in the arm. If a submodule is inserted, current may flow from an input terminal of the submodule via the first switch to the capacitor of the submodule and from the capacitor to an output terminal of the submodule for charging the capacitor. For discharging the capacitor, the current flow may be inverted.

According to several embodiments, the control unit is configured to, for bypassing one of the plurality of submodules, open the first switching element of the respective submodule is and close the second switching element of the respective submodule, such that the capacitor of the respective submodule is disconnected from the arm.

According to several embodiments, the control unit is configured to, for blocking one of the plurality of submodules, close the first and the second switching element of the respective submodule. In case the first switching element comprises a freewheeling diode, the capacitor of the respective submodule may be charged or not, depending on the direction of the current in the arm.

Herein, an open switching element is meant to be in an off-state, that is in a high-resistance state. Further, a closed switching element is meant to be in an on-state, that is in a low-resistance state. It is noted that the term "opening a switching element" also includes keeping the switching element open. Analogously, the term "closing a switching element" also includes keeping the switching element closed.

According to several embodiments, in order to control the charging current at the reference current, the control unit is configured to determine a reference arm voltage across the arm depending on the reference current and a current flowing in the arm. The control unit is further configured to control a voltage across the arm at the reference arm voltage by controlling the switching arrangements of the plurality of submodules or of a subset of the plurality of submodules.

According to several embodiments, the control of the switching arrangements is carried out to control respective voltages across the capacitors or a subset of the capacitors at respective reference capacitor voltages. The reference capacitor voltages are determined by the reference arm voltage.

Depending on the reference arm voltage at a given time instant, all submodules or a subset of submodules of the plurality of submodules may be inserted in the arm at the time instant. The number of inserted submodules may vary during the second period of time.

According to several embodiments, the control unit is configured to control the switching arrangements of the plurality of submodules or a subset of the plurality based on a carrier-less modulation scheme in order to control the voltage across the arm.

According to several embodiments, the carrier-less modulation scheme comprises a nearest level control, NLC.

According to several embodiments, the control unit is configured to control the switching arrangements of the plurality of submodules or a subset of the plurality such that the voltage across the arm lies at the reference arm voltage or within a predefined tolerance range around the reference arm voltage in order to control the voltage across the arm.

According to several embodiments, the tolerance range lies in the order of plus or minus several percent, for example approximately 10 percent, of the reference arm voltage.

According to several embodiments, the control unit is configured to control the switching arrangements of the plurality of submodules or a subset of the plurality such that the voltages across the capacitors lie within a further predefined tolerance range around the reference capacitor voltage in order to control the voltage across the arm.

According to several embodiments, the further tolerance band lies in the order of plus or minus several percent, for example approximately 10 percent, of the reference capacitor voltage.

By allowing for a predetermined tolerance range, the number of switching events during the second period may be reduced compared to other switching schemes, for example carrier based switching schemes such as pulse width modulation schemes, for example phase shifted carrier pulse width modulation schemes. Therefore, the degradation of the switching arrangements or switching elements may be reduced and the lifetime of the MMC may therefore be further improved. Again, this may be particularly relevant for applications that require a relatively high number of restarts of the MMC.

According to several embodiments of the MMC, the switching arrangement of one of the submodules, in particular the first and/or the second switching element, comprises at least one insulated gate bipolar transistor, IGBT.

According to several embodiments of the MMC, the control unit comprises a gate drive for controlling the switching arrangements, in particular the switching elements, for example the IGBTs.

According to the improved concept, also a high voltage testing source is provided. The high voltage testing source comprises an MMC according to the improved concept.

By means of the MMC, the high voltage testing source may be used to supply various test voltage profiles to a high voltage electric device to be tested.

According to the improved concept, also a method for controlling a pre-charging process for an MMC, in particular an MMC according to the improved concept, is provided. The MMC comprises an arm with a plurality of submodules coupled in series. Each of the submodules comprises a capacitor. The method includes connecting the arm to a constant voltage source for a first period of time. After the first period of time a charging current is fed to the arm and the charging current is controlled at a predetermined constant reference current for a second period of time.

According to the improved concept, also a method for high voltage testing of an electrical device is provided. The method includes pre-charging an MMC of a high voltage testing source comprising the MMC. The pre-charging is carried out according to a method for controlling a pre-charging process according to the improved concept.

According to several implementations of the method for high voltage testing, a test voltage is generated by means of the high voltage testing source after the pre-charging. The test voltage is then applied to the electric device.

Further implementations and embodiments of the methods according to the improved concept follow readily from the various implementations and embodiments of the MMC or the high voltage testing source according to the improved concept and vice versa. In particular, individual or several components or arrangements described with respect to the MMC or the high voltage testing source may be implemented accordingly for a method according to the improved system.

In the following, the invention is explained in detail with respect to exemplary implementations by reference to the drawings. Components that are functionally identical or have an identical effect may be denoted by identical reference signs. Identical components or components with identical functions or effects may be described only with respect to the figure where they occur first. Their description is not necessarily repeated in subsequent figures.

In the drawings,
- Figure 1a: shows a block diagram of an exemplary implementation of an MMC according to the improved concept;
- Figure 1b: shows a block diagram of an arm of a further exemplary implementation of an MMC according to the improved concept;
- Figure 1c: shows a block diagram of a sub module of a further exemplary implementation of an MMC according to the improved concept;
- Figure 2: shows a control diagram applicable for an exemplary implementation of a method according to the improved concept;
- Figure 3a: shows a set of curves representing capacitor voltages in a further exemplary implementation of an MMC according to the improved concept; and
- Figure 3b: shows a curve representing current flowing in an arm of a further exemplary implementation of an MMC according to the improved concept.

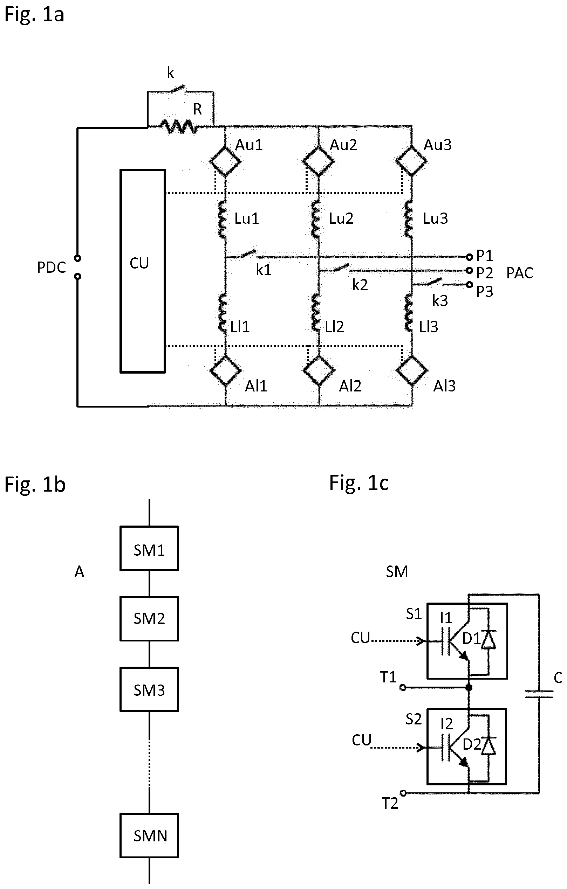

Figure 1a shows a block diagram of an exemplary implementation of an MMC according to the improved concept. The MMC comprises several, in the particular non-limiting example three, upper arms Au1, ... Au3, and equally many, in the particular non-limiting example three, lower arms All, A12, A13. Respective pairs of upper and lower arms are coupled in series, for example Au1/Al1, Au2/Al2 and Au3/Al3. A respective terminal P1, P2, P3 of an AC port PAC of the MMC is connected between each of the series connected arms. In the shown example, a respective upper inductive component Lu1, Lu2, Lu3 is connected between each of the upper arms Au1, ... Au3 and the respective terminal P1, P2, P3. Analogously, a respective lower inductive component Ll1, Ll2, Ll3 is connected between each of the lower upper arms Al1, ... Al3 and the respective terminal P1, P2, P3. Each pair of series connected upper and lower arms Au1/Al1, Au2/Al2, Au3/A13 forms, together with the respective upper and lower inductive components Lu1/Ll1, Lu2/Ll2, Lu3/Ll3, a leg of the MMC.

Alternatively or in addition, to the upper and lower inductive components Lu1, ..., Lu3, Ll1, .. L13, a respective inductive component (not shown) may be connected between each of the terminals P1, P2, P3 and the respective leg.

Optionally, the MMC may comprise a respective switch k1, k2, k3 arranged between each of the legs and the respective terminal P1, P2, P3 to disconnect the respective leg from the respective terminal P1, P2, P3.

The upper arms Au1, Au2, Au3 are connected to each other and to a DC port PDC. The lower arms All, A12, A13 are connected to each other and to the DC port PDC.

The MMC further comprises a resistor R coupled between the upper arms Au1, Au2, Au3 and the DC port PDC. Alternatively, the resistor R may be coupled between the lower arms Al1, A12, A13 and the DC port PDC or a further resistor (not shown) may be coupled between the lower arms All, A12, A13 and the DC port PDC.

Optionally, the MMC comprises a further switch k for bypassing the resistor R.

The MMC comprises a control unit CU coupled to each of the arms Au1, ... Au3, Al1, ..., Al3. Optionally, the control unit CU may be coupled to the switches k, k1, ... k3 for opening and closing each of them.

Figure 1b shows a block diagram of an arm A of a further exemplary implementation of an MMC according to the improved concept. For example, the arm A may represent one of the arms Au1, ... Au3, All, ..., A13 shown in Figure 1a.

The arm A comprises a plurality of submodules SM1, SM2, SM3, SMN coupled in series to each other. The number of four submodules shown is to be understood as a non-limiting example. In particular, according to implementations of the improved concept, the arm A may comprise any number of submodules equal to or greater than two, as indicated by the dotted lines in Figure 1b.

Figure 1c shows a block diagram of a submodule SM of a further exemplary implementation of an MMC according to the improved concept. For example, the submodule SM may represent one of the submodules SM1, ..., SMN shown in Figure 1b.

As a non-limiting example, the submodule SM is implemented according to a half-bridge topology. According to other embodiments, the submodule may be implemented differently, for example according to a full-bridge topology.

According to the half bridge topology, the submodule comprises a capacitor C with one terminal coupled to an input terminal T1 of the submodule SM via a first switching element S1. Another terminal of the capacitor C is coupled to an output terminal T2 of the submodule. A second switching element S2 is connected between the input terminal T1 and the output terminal T2.

The first and the second switching elements S1, S2 may for example each comprise a respective transistor I1, I2, for example an insulated gate bipolar transistor, IGBT. The transistors I1, I2 are depicted in Figure 1c as normally-on n-type transistors. As obvious for the skilled reader, other choices are possible as well.

The first switching element S1 may be connected to the capacitor via a collector terminal of the first transistor I1 and to the input terminal T1 via an emitter terminal of the first transistor I1. Optionally, a first diode D1 may be connected to the first transistor T1 such that a cathode of the diode D1 is connected to the collector terminal of the first transistor T1 and an anode of the diode D1 is connected to the emitter terminal of the first transistor T1. The second switching element S2 may be connected to the capacitor via an anode terminal of the second transistor I2 and to the input terminal T1 via a collector terminal of the second transistor I2. Optionally, a second diode D2 may be connected to the second transistor T2 such that a cathode of the diode D2 is connected to the collector terminal of the second transistor T2 and an anode of the diode D2 is connected to the emitter terminal of the second transistor T2. Respective gate terminals of the transistors T1, T2 are coupled to and may be controlled by the control unit CU.

The input terminal T1 is for example coupled to the AC port PAC or the respective inductive element of the arm either directly or via one or more other submodules of the same arm, depending on the location of the particular submodule within the series connection of submodules. The output terminal T2 is for example coupled to the DC port PDC either directly or via the resistor R and/or via one or more other submodules of the same arm, depending on the location of the particular submodule within the series connection of submodules.

The following description is directed mostly to the first upper arm Aul as a representative example. The operation with respect to the other arms of the MMC is analogous.

During a first stage of a pre-charging process, the DC port PDC is connected to a constant DC voltage for a first period of time. During the first stage, all submodules of the arm Aul are uncontrolled. Therefore, during the first stage, the capacitors of the submodules of arm Aul are charged without the charging current being controlled. The switches k, k1, k2, k3 are all opened during the first stage.

The first period of time may for example be chosen such that the voltage across all capacitors of arm Aul reaches an intermediate pre-charging voltage. Furthermore, the intermediate pre-charging voltage may be chosen equal to or larger than a minimum operating voltage for the control unit CU or a gate drive (not shown) for driving the switching elements S1, S2, in particular the transistors I1, I2. The gate drive is for example comprised by the control unit CU.

During a second stage of the pre-charging process, a charging current is fed to the arm Aul and controlled by the control unit CU at a constant reference current. To this end, for example a reference voltage across the individual capacitors is determined depending on the reference current and a present current flowing through the arm Aul. The control unit CU may then insert or bypass the capacitors of the arm Aul repeatedly during the second stage to keep the voltages across the capacitors within a tolerance range around the reference voltage across the capacitors. For the switching during the second stage, the control unit may for example use an NLC scheme. During the second stage the switches k1, k2, k3 are open, while the switch k may be closed for bypassing the resistor R.

The second stage ends after a second period of time when the voltage across the arm Aul lies within a tolerance range around a target pre-charging voltage or when all capacitor voltages reach corresponding values.

After the second stage, nominal MMC operation may start.

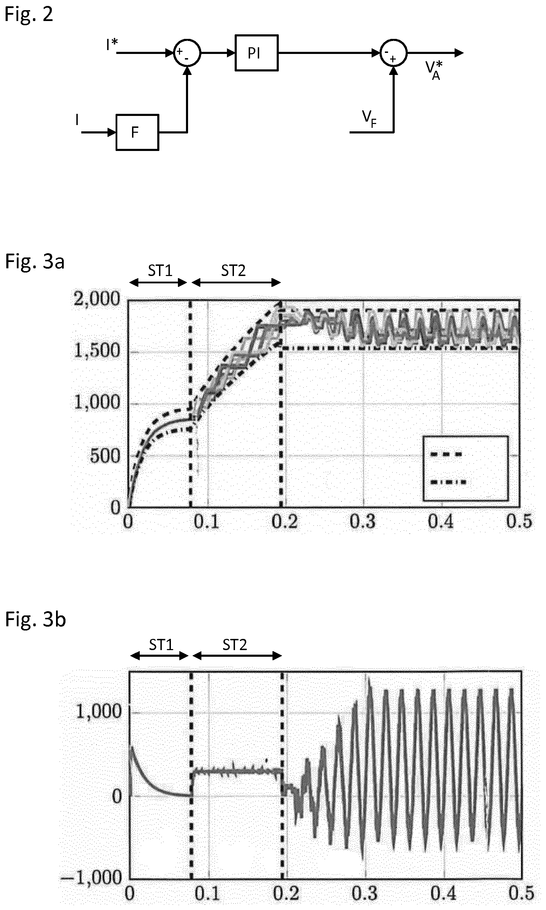

Figure 2 shows a control diagram useable in an exemplary implementation of a method according to the improved concept for determining the actual reference arm voltage or reference capacitor voltages.

The present arm current I is optionally filtered by a low pass filter F and subtracted from the reference current I*. The resulting difference is fed for example to a proportional integral controller PI. The output of the proportional integral controller PI is subtracted from a feed forward term V_{F}, which results in the reference arm voltage V_{A}*.

The feed forward term V_{F} may enhance a dynamic performance of the control. The feed forward term V_{F} may for example depend on the intermediate pre-charging voltage, the resistance of the resistor R and the present arm current I. For example, the feed forward term V_{F} may be given by V_{F} = Vᵢₙₜ - ∑|R|*Iᵢ, wherein the sum runs over all arms I, Iᵢ is the respective present arm current of arm i, Vᵢₙₜ is the intermediate pre-charging voltage and |R| is the resistance of the resistor R.

Figure 3a shows a set of curves representing capacitor voltages in a further exemplary implementation of an MMC according to the improved concept, for example an implementation as explained with respect to Figures 1a, 1b and 1c. The capacitor voltages in volt are plotted versus time in seconds. It can be seen that there is no significant overshoot of capacitor voltages at the end of the second stage.

Figure 3b shows a corresponding arm current in ampere. During the first stage ST1, the voltages are essentially indistinguishable and approach a capacitor voltage corresponding to the intermediate pre-charging voltage exponentially. The current correspondingly goes towards zero. During the second stage ST2, the individual capacitor voltages are kept within a tolerance range shown as dashed and dash-dotted lines, respectively. The corresponding charging current is constant or approximately constant. After the second stage has ended, nominal operation of the MMC begins.

Tests have shown that the improved concept is also robust against variations in the capacitor properties. For example, considering faulty capacitors having only around 80% of the rated voltage or capacitors with around 120% of the rated voltage, the capacitor voltages could still be kept well within the tolerance range.

By means of an MMC or a method according to the improved concept, a fast and controlled pre-charging process may be achieved. The approach may reduce overshoots in the capacitor voltages at the end of the pre-charging process. Additionally, the number of switching events may be reduced compared to other schemes. Therefore, degeneration of the capacitors and/or switching elements and a corresponding reduction in lifetime of the MMC may be avoided.

### Reference signs

- CU: control unit
- A, Au1, Au2, Au3: arms
- Al1, Al2, Al3:
- Lu1, Lu2, Lu3,: inductive components
- Ll1, Ll2, Ll3:
- k, k1, k2, k3: switches
- R: resistor
- PAC, PDC: ports
- P1, P2, P3: terminals of AC port
- SM, SM1, SM2, SM3, SMN: submodules
- S1, S2: switching elements
- T1, T2: input and output terminal
- I1, I2: transistors
- D1, D2: diodes
- C: capacitor
- I: arm current
- I*: reference current
- PI: proportional integral controller
- F: low pass filter
- V_{F}: feed forward term
- V*_{A}: reference arm voltage
- ST1, ST2: stages of pre-charging

## Claims

1. Modular multilevel converter for a high voltage testing source comprising
- an arm (A), the arm (A) comprising a plurality of submodules (SM1, SM2, ..., SMN) coupled in series, wherein each of the submodules (SM1, ..., SMN) comprises a capacitor (C); and
- a control unit (CU), which is, in order to control a pre-charging process of the capacitors (C) prior to a start of operation of the modular multilevel converter, configured to
- connect the arm (A) to a constant voltage source for a first period of time; and,
- for a second period of time after the first period of time, feed a charging current to the arm (A) and control the charging current at a predetermined constant reference current.

2. Modular multilevel converter according to claim 1, wherein each of the submodules (SM1, ..., SMN) comprises a switching arrangement (S1, S2) for inserting, bypassing and/or blocking the respective submodule (SM1, ..., SMN).

3. Modular multilevel converter according to claim 2, wherein
- each switching arrangement (S1, S2) comprises a first switching element (S1) and a second switching element (S2); and
- the switching elements (S1, S2) and the respective capacitor (C) of a respective submodule are arranged according to a half-bridge topology.

4. Modular multilevel converter according to claim 3, wherein the control unit (CU) is configured to, for inserting one of the plurality of submodules (SM1, ..., SMN), close the first switching element (S1) and open the second switching element (S2) of the respective submodule such that the capacitor (C) of the respective submodule may be charged or discharged.

5. Modular multilevel converter according to one of claims 2 to 4, wherein in order to control the charging current at the reference current, the control unit (CU) is configured
- to determine a reference arm voltage across the arm (A) depending on the reference current and on a current flowing in the arm (A); and
- to control a voltage across the arm (A) at the reference arm voltage by controlling the switching arrangements (S1, S2) of the plurality of submodules (SM1, ..., SMN).

6. Modular multilevel converter according to claim 5, wherein in order to control the voltage across the arm (A), the control unit (CU) is configured to control the switching arrangements (S1, S2) of the plurality of submodules (SM1, ..., SMN) based on a carrier-less modulation scheme.

7. Modular multilevel converter according to claim 6, wherein the carrier-less modulation scheme comprises a nearest level control scheme.

8. Modular multilevel converter according to one of claims 5 to 7, wherein in order to control the voltage across the arm (A), the control unit (CU) is configured to control the switching arrangements (S1, S2) of the plurality of submodules (SM1, ..., SMN) such that the voltage across the arm (A) lies at predefined reference arm voltage or within a predefined tolerance range.

9. Modular multilevel converter according to one of claims 1 to 8, wherein during the first period, the arm (A) is connected to the constant voltage source via a resistor (R).

10. Modular multilevel converter according to claim 9, wherein the control unit (CU) is configured to bypass the resistor (R) during the second period.

11. High voltage testing source comprising a modular multilevel converter according to one of claims 1 to 10.

12. Method for controlling a pre-charging process for a modular multilevel converter, the modular multilevel converter comprising an arm (A), the arm (A) comprising a plurality of submodules (SM1, SM2, ..., SMN) coupled in series, wherein each of the submodules (SM1, ..., SMN) comprises a capacitor (C), wherein the method includes
- connecting the arm (A) to a constant voltage source for a first period of time; and
- for a second period of time after the first period of time, feeding a charging current to the arm (A) and controlling the charging current at a predetermined constant reference current.

13. Method according to claim 12, further including
- determining a reference arm voltage across the arm (A) depending on the reference current and on a current flowing in the arm (A); and
- controlling a voltage across the arm (A) at the reference arm voltage.

14. Method according to claim 13, wherein in order to control the voltage across the arm, switching arrangements (S1, S2) of the plurality of submodules (SM1, ..., SMN) are controlled based on a carrier-less modulation scheme, in particular a nearest level control scheme.

15. Method for high voltage testing of an electrical device including pre-charging a modular multilevel converter of a high voltage test source according to a method according to one of claims 12 to 14.
